# EUROPEAN PATENT APPLICATION

(11) **EP 4 804 001 A1**
(43) Date of publication of application: **09.09.2026**
(21) Application number: 24883905.2
(22) Date of filing: 30.05.2024
(51) Int. Cl.: G06F 3/06

(54) **CONTROL METHOD FOR STORAGE DEVICE, AND STORAGE DEVICE AND ELECTRONIC DEVICE**

(30) Priority: 02.11.2023 CN 202311456710
(71) Applicant: Shanghai Longsys Digital Technology Co., Limited, Shanghai 201306 (CN)
(72) Inventor: HE, Xuesong, Shanghai 201306 (CN)
(74) Representative: De Arpe Tejero, Manuel
(86) International application number: PCT/CN2024/096474
(87) International publication number: WO 2025/091893

(57) **Abstract**

A control method for a storage device includes: writing (S11), through a target mode, the to-be-written data into a storage unit; the target mode including a first mode and a second mode; in the first mode, the to-be-written data being firstly stored in a storage unit in a first type and then migrated to a storage unit in a second type; in the second mode, the to-be-written data being directly stored in the storage unit in the second type; counting (S12) a target erase/write count according to the target mode, where the target erase/write count is less than a sum of an actual erase/write count of the storage unit in the first type and an actual erase/write count of the storage unit in the second type; and in response to the target erase/write count being greater than an erase/write count threshold, shutting down (S13) the first mode.

## Description

### CROSS REFERENCE TO RELATED APPLICATIONS

The present application claims the priority of the Chinese patent application No. 202311456710.0, filed on November 2, 2023, contents of which are incorporated herein by its entireties.

### TECHNICAL FIELD

Embodiments of the present disclosure relate to the technical field of storage devices, and more specifically, to a control method for a storage device, a storage device, and an electronic device.

### BACKGROUND

When a storage device is in use, in order to improve write performance of the storage device, data may be usually written by means of cache writing.

In practice, the inventor of the present disclosure found that, when data are written by means of cache writing, an increased number of erases and writes may be caused, such that larger write amplification may be generated, and a service life of the storage device may be reduced.

### SUMMARY

The present disclosure provides a control method for a storage device, a storage device, and an electronic device.

The present disclosure provides a control method for a storage device, including: in response to to-be-written data sent by a host, writing, through a target mode, the to-be-written data into a storage unit; where the target mode includes a first mode and a second mode; in the first mode, the to-be-written data is firstly stored in a storage unit in a first type and then migrated from the storage unit in the first type to a storage unit in a second type; in the second mode, the to-be-written data is directly stored in the storage unit in the second type; where the amount of data storable in the storage unit in the first type is less than the amount of data storable in the storage unit in the second type; counting a target erase/write count according to the target mode; where the target erase/write count is less than a sum of an actual erase/write count of the storage unit in the first type and an actual erase/write count of the storage unit in the second type; and in response to the target erase/write count being greater than an erase/write count threshold, shutting down the first mode.

In another aspect, the present disclosure provides a storage device, including a processor and a storage unit. The processor is coupled to the storage unit and a host and is configured to execute instructions during operation to implement the control method in the above.

In another aspect, the present disclosure provides an electronic device, including a processing device and a storage device. The processing device is coupled to the storage device, and is configured to execute instructions during operation to implement the control method in the above.

Details of one or more embodiments of the present disclosure are provided in the accompanying drawings and description below. Other features, objects, and advantages of the present disclosure will become apparent from the description, drawings, and claims.

### BRIEF DESCRIPTION OF THE DRAWINGS

In order to more clearly illustrate technical solutions in the embodiments of the present disclosure, the accompanying drawings required for describing the embodiments will be briefly introduced below. Obviously, the accompanying drawings in the following description are only some embodiments of the present disclosure. Any ordinary skilled artisan in the art may obtain other accompanying drawings based on these accompanying drawings without making any creative work.
FIG. 1 is a flow chart of a control method for a storage device according to a first embodiment of the present disclosure.
FIG. 2 is a flow chart of a block S11 according to an embodiment of the present disclosure.
FIG. 3 is a flow chart of the control method for the storage device according to a second embodiment of the present disclosure.
FIG. 4 is a diagram showing a relationship between the erase/write count and a fail bit count corresponding to a storage unit in a first type and a storage unit in a second type.
FIG. 5 is a flow chart of the control method for the storage device according to a third embodiment of the present disclosure.
FIG. 6 is a diagram showing threshold voltages corresponding to the storage unit in the first type and the storage unit in the second type, according to an embodiment of the present disclosure.
FIG. 7 is a diagram showing threshold voltages corresponding to the storage unit in the first type according to the third embodiment of the present disclosure.
FIG. 8 is a flow chart of the control method for the storage device according to a fourth embodiment of the present disclosure.
FIG. 9 is a flow chart of the control method for the storage device according to a fifth embodiment of the present disclosure.
FIG. 10 is a flow chart showing a principle of writing to-be-written data into the storage unit according to an embodiment of the present disclosure.
FIG. 11 is a structural schematic diagram of a storage device according to an embodiment of the present disclosure.
FIG. 12 is a structural schematic diagram of an electronic device according to an embodiment of the present disclosure.

### DETAILED DESCRIPTIONS

The technical solutions in the embodiments of the present disclosure will be clearly and completely described below by referring to the accompanying drawings in the embodiments of the present disclosure. Obviously, the described embodiments are only a part of, not all of, the embodiments of the present disclosure. All other embodiments, which are obtained by any ordinary skilled artisan in the art based on the embodiments in the present disclosure without creative work, shall fall within the scope of the present disclosure.

In the related art, in order to improve writing performance of a storage device, a cache writing method (WB feature) may usually be applied to write to-be-written data into the storage device. That is, the to-be-written data may be firstly written into a flash memory, and then the corresponding data may be moved to another storage unit. This is because a speed of writing data into the flash memory may be fast, such that the writing performance of the storage device may be improved. However, for the same amount of to-be-written data, the number of flash memory blocks occupied by the cache writing method is much greater than the number of flash memory blocks occupied by performing a direct writing method. Moreover, after writing the to-be-written data into the flash memory, the data may further need to be moved to another storage unit. Therefore, a large erase/write count may be generated, such that large write amplification may be caused, and a service life of the storage device may be reduced.

Therefore, the present disclosure provides a control method for a storage device. The to-be-written data may be written into a storage unit through a target mode including a first mode and/or a second mode. A corresponding target erase/write count may be obtained, and the writing mode may be controlled based on the target erase/write count. In this way, the writing performance of the storage device may be improved, the write amplification may be reduced, and the service life of the storage device may be extended.

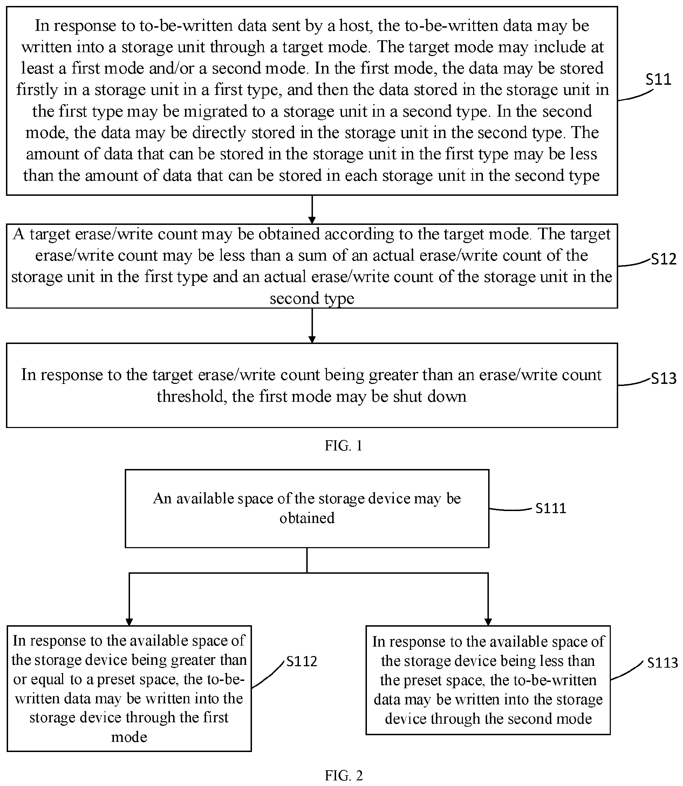

As shown in FIG. 1, FIG. 1 is a flow chart of a control method for a storage device according to a first embodiment of the present disclosure.

As shown in FIG. 1, the control method for the storage device of the present disclosure may include the following blocks.

In S11, in response to to-be-written data sent by a host, the to-be-written data may be written into a storage unit through a target mode. The target mode may include at least a first mode and/or a second mode. In the first mode, the data may be stored firstly in a storage unit in a first type, and then the data stored in the storage unit in the first type may be migrated to a storage unit in a second type. In the second mode, the data may be directly stored in the storage unit in the second type. The amount of data that can be stored in the storage unit in the first type may be less than the amount of data that can be stored in each storage unit in the second type.

The host may be a communication device that is capable of sending commands, such as a mobile phone, a tablet, a computer, and so on. The to-be-written data may be data in any type that need to be stored, such as a text, a number, an image, an audio, a video, and so on.

In some embodiments, the storage device may include a plurality of storage units. Some of the plurality of storage units may be storage units in the first type, and the other of the plurality of storage units may be storage units in the second type. Alternatively, one storage unit may serve as the storage unit in the first type during a certain period of time and may serve as the storage unit in the second type during another period of time. Configuration of the storage unit may be determined according to practical conditions.

The storage unit in the first type may serve as a buffer area, and the storage unit in the second type may serve as a normal storage area.

In some embodiments, the target mode may include only the first mode, or include only the second mode, or include both the first mode and the second mode.

As shown in FIG. 2, FIG. 2 is a flow chart of the S11 according to an embodiment of the present disclosure.

As shown in FIG. 2, the S11 may include the following.

In S111, an available space of the storage device may be obtained.

The available space of the storage device may include available spaces of all storage units to be used, and an available space corresponding to each storage unit may be determined.

In S112, in response to the available space of the storage device being greater than or equal to a preset space, the to-be-written data may be written into the storage device through the first mode.

In order to ensure the first mode to be performed normally, a threshold may be set, and that is, the preset space may be set. When the to-be-written data is written into the storage unit through the first mode, the available space for caching and moving may be sufficient.

Specifically, when it is detected that the available space of the storage device is greater than or equal to the preset space, the to-be-written data may be written into the storage device through the first mode. That is, the target mode may include only the first mode. In the first mode, the host may send the to-be-written data to the storage device. In response to receiving the to-be-written data, the storage device may store the to-be-written data in the storage unit in the first type. When the storage device is idle or an available bandwidth is sufficient, the data cached in the storage unit in the first type may be moved to the storage unit in the second type. For moving the data cached in the storage unit in the first type, a direct writing method may be performed to flush the data cached in the storage unit in the first type to the storage unit in the second type. The relevant data in the storage unit in the first type may be invalid, such that the storage unit in the first type may release more space.

In S113, in response to the available space of the storage device being less than the preset space, the to-be-written data may be written into the storage device through the second mode.

Specifically, when it is detected that the available space of the storage device is less than the preset space, the to-be-written data may be written into the storage device through the second mode. That is, the target mode may include only the second mode. In the second mode, the host may send the to-be-written data to the storage device. In response to receiving the to-be-written data, the storage device may store the to-be-written data in the storage unit in the second type, i.e., directly store the to-be-written data into the normal storage area.

In some embodiments, the target mode may include both the first mode and the second mode. For example, at an early stage of a storage process, the available space of the storage device may be greater than or equal to the preset space, and at a later stage of the storage process, the available space of the storage device may be less than the preset space. That is, in a case that a large amount of data needs to be stored in one storage process, a mixed mode of the first mode and the second mode may be performed. In a case of mixing the first mode and the second mode, the available space of the storage device that is obtained in real time may be compared with the preset space. During a stage when the available space of the storage device is greater than or equal to the preset space, the first mode may be performed to write the to-be-written data into the storage device; and during a stage when the available space of the storage device is less than the preset space, the second mode may be performed to write the to-be-written data into the storage device.

In S12, a target erase/write count may be obtained according to the target mode. The target erase/write count may be less than a sum of an actual erase/write count of the storage unit in the first type and an actual erase/write count of the storage unit in the second type.

The erase/write count is the number of times that data erasing and writing is performed during writing the to-be-written data into the storage unit. The target erase/write count is the number of times that data erasing and writing is performed corresponding to writing the to-be-written data into the storage unit through the target mode. The actual erase/write count of the storage unit in the first type may be the number of times that data erasing and writing is performed when the to-be-written data is stored in the storage unit first type of in the first type. The actual erase/write count of the storage unit in the second type may be the number of times that data erasing and writing is performed when the to-be-written data is stored in the storage unit in the second type.

Specifically, after writing the to-be-written data into the storage unit through the target mode, the target erase/write count corresponding to the target mode may be counted, and the sum of the actual erase/write count of the storage unit in the first type and the actual erase/write count of the storage unit in the second type may be counted. Since the target erase/write count corresponding to the target mode is less than the sum of the actual erase/write count of the storage unit in the first type and the actual erase/write count of the storage unit in the second type, write amplification may be effectively reduced, and the service life of the storage device may be extended.

For example, a capacity of the storage unit in the first type may be 1 GB, and a capacity of the storage unit in the second type may be 3 GB. When writing 3 GB of to-be-written data into the storage unit through the second mode, the direct writing method may be performed, and the 3 GB of to-be-written data may be directly written into the storage unit in the second type. During the writing process, one erase/write may be performed on the storage unit in the second type, and a write amplification factor may be 1/1 = 1. When writing the 3 GB of to-be-written data into the storage unit through the first mode, the 3 GB of to-be-written data may need to be firstly written into three storage units in the first type, each having the capacity of 1 GB. The host may be quickly replied to, when a system is idle or have the sufficient bandwidth, the 3 GB of to-be-written data stored in the three storage units in the first type may be moved to the storage unit in the second type with the capacity of 3 GB. By storing the data in the storage units in the first type, a storage efficiency may be improved. When writing the data, one erase/write may be performed on each storage unit in the first type with the capacity of 1 GB. When moving the data to the storage unit in the second type, the erase/write may be performed on the storage unit in the second type. Therefore, the erase/write count for the first mode may be four, and the write amplification factor may be 4/1 = 4.

That is, the sum of the actual erase/write count for the storage unit in the first type and the actual erase/write count for the storage unit in the second type may be 3 + 1 = 4. The target erase/write count is less than 4, and therefore, the write amplification may be effectively reduced, and the service life of the storage device may be extended.

In S13, in response to the target erase/write count being greater than an erase/write count threshold, the first mode may be shut down.

In order to determine whether the service life of the storage unit is exhausted, the erase/write count threshold may be set.

Specifically, the erase/write count threshold may be determined according to an allowable erase/write count of the storage units in the storage device. After writing the to-be-written data into the storage unit through the target mode and obtaining the corresponding target erase/write count, the target erase/write count may be compared with the erase/write count threshold. When the target erase/write count is greater than the erase/write count threshold, it may be indicated that the service life of the storage unit may be exhausted. Therefore, the first mode may need to be shut down to terminate any erasing and writing operation performed on the storage unit.

In the present embodiment, by writing the to-be-written data into the storage unit through the target mode including the first mode and/or the second mode, the corresponding target erase/write count may be obtained, and the target erase/write count may be set to be less than the sum of the actual erase/write count for the storage unit in the first type and the actual erase/write count for the storage unit in the second type. In this way, the write amplification may be reduced. That is, the writing mode may be controlled based on the target erase/write count, such that the writing performance of the storage device may be improved, the write amplification may be reduced, and the service life of the storage device may be extended.

In order to further reduce the write amplification, setting may be performed based on a wear coefficient.

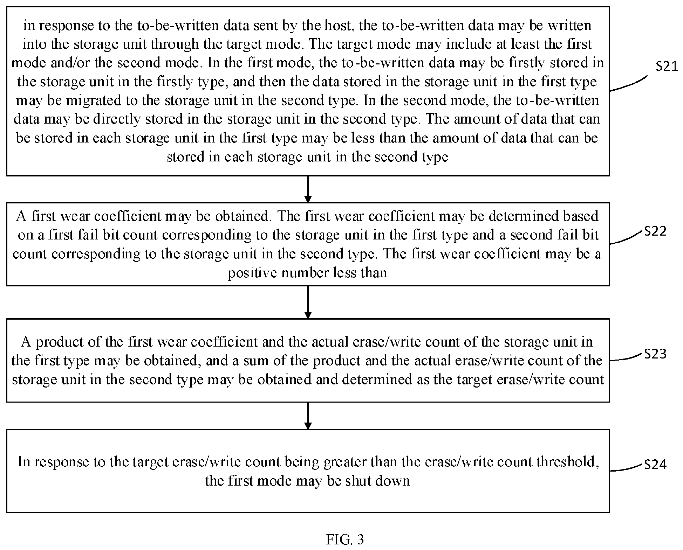

As shown in FIG. 3, FIG. 3 is a flow chart of the control method for the storage device according to a second embodiment of the present disclosure.

As shown in FIG. 3, the method may include the following blocks.

In S21, in response to the to-be-written data sent by the host, the to-be-written data may be written into the storage unit through the target mode. The target mode may include at least the first mode and/or the second mode. In the first mode, the to-be-written data may be firstly stored in the storage unit in the firstly type, and then the data stored in the storage unit in the first type may be migrated to the storage unit in the second type. In the second mode, the to-be-written data may be directly stored in the storage unit in the second type. The amount of data that can be stored in each storage unit in the first type may be less than the amount of data that can be stored in each storage unit in the second type.

Parts that are identical to the first embodiment may not be repeated herein.

In S22, a first wear coefficient may be obtained. The first wear coefficient may be determined based on a first fail bit count corresponding to the storage unit in the first type and a second fail bit count corresponding to the storage unit in the second type. The first wear coefficient may be a positive number less than 1.

The first wear coefficient may be an internal operation parameter corresponding to erasing and writing performed on the storage unit in the first type. The first wear coefficient may be configured to manage the service life of the storage device and to adjust the write amplification. For a same erase/write operation, the fail bit count (FBC) caused by the storage unit in the first type may be smaller than that caused by the storage unit in the second type.

In some embodiments, the first wear coefficient may be obtained in advance in the following manner.

Specifically, the same erase/write count may be performed on the storage unit in the first type and one the storage unit in the second type, and the first fail bit count corresponding to the storage unit in the first type and the second fail bit count corresponding to the storage unit in the second type may be respectively obtained. Furthermore, the first wear coefficient may be determined based on the first fail bit count and the second fail bit count.

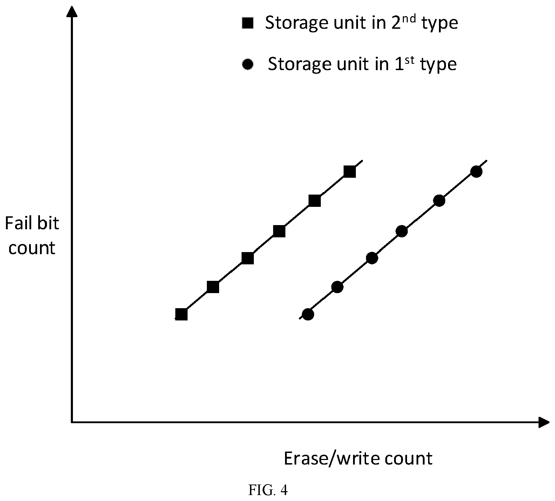

As shown in FIG. 4, FIG. 4 is a diagram showing a relationship between the number of erases/writes and the fail bit count corresponding to the storage unit in the second type and the storage unit in the second type.

As shown in FIG. 4, when the same number of times of erasing/writing are performed, the second fail bit count corresponding to the storage unit in the second type may be twice the first fail bit count corresponding to the storage unit in the first type. Therefore, the first wear coefficient may be 1/2 = 0.5.

In S23, a product of the first wear coefficient and the actual erase/write count of the storage unit in the first type may be obtained, and a sum of the product and the actual erase/write count of the storage unit in the second type may be obtained and determined as the target erase/write count.

The first wear coefficient may be taken into account for calculating the target erase/write count.

Specifically, the first wear coefficient may be multiplied by the actual erase/write count of the storage unit in the first type, so as to obtain the product; the product may be added to the actual erase/write count of the storage unit in the second type; and the obtained sum may be the target erase/write count.

Accordingly, in a case that the first wear coefficient may be 0.5, the actual erase/write count of the storage unit in the first type may be k, the actual erase/write count of the storage unit in the second type may be m, and the target erase/write count may be n, then n = k * 0.5 + m. For example, the capacity of the storage unit in the first type may be 1 GB, the capacity of the storage unit in the second type may be 3 GB. The amount of to-be-written data may be 3 GB. When writing the to-be-written data through the first mode, the actual erase/write count of the storage unit in the first type may be 3, and the actual erase/write count of the storage unit in the second type may be 1. In this case, the target erase/write count n = 3 * 0.5 + 1 = 2.5, which may be less than the sum (which may be 4) of the actual erase/write count of the storage unit in the first type and the actual erase/write count of the storage unit in the second type. That is, the write amplification may be corrected from 4 to 2.5, and the original 4 times write amplification may be reduced by 37.5%.

In S24, in response to the target erase/write count being greater than the erase/write count threshold, the first mode may be shut down.

Parts identical to the first embodiment may not be repeated herein.

In the present embodiment, the to-be-written data may be written into the storage unit through the target mode including the first mode and/or the second mode. The corresponding target erase/write count may be obtained, and the first wear coefficient affecting the target erase/write count may be obtained. In this way, the target erase/write count may be less than the sum of the actual erase/write count of the storage unit in the first type and the actual erase/write count of the storage unit in the second type, such that the write amplification may be reduced. That is, the writing mode may be controlled based on the target erase/write count, the writing performance of the storage device may be improved, the write amplification may be effectively reduced, and the service life of the storage device may be extended.

In order to further reduce the write amplification, the wear coefficient may be determined based on an erase state threshold voltage and a program state threshold voltage, such that the write amplification may be reduced.

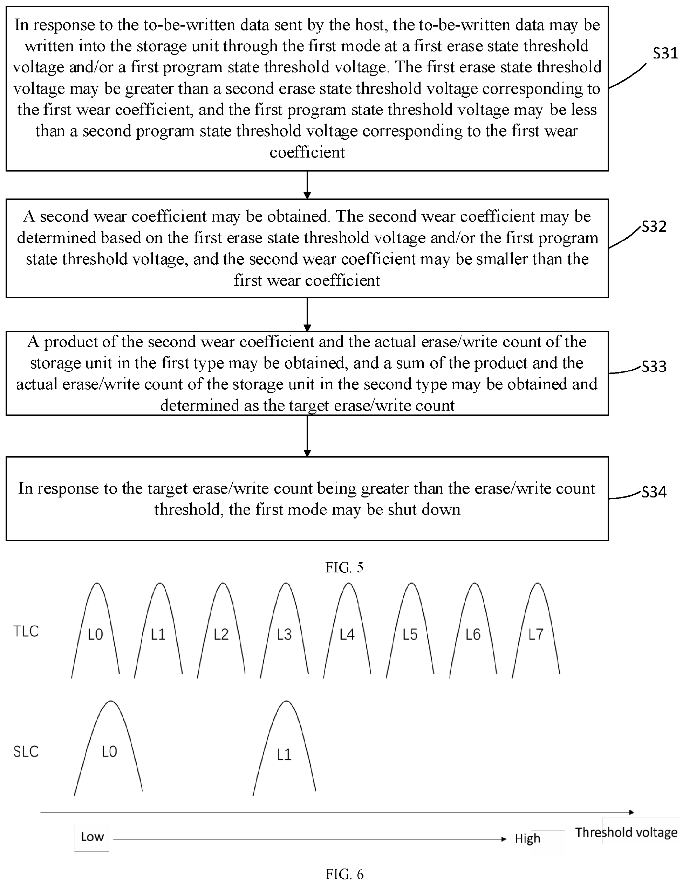

As shown in FIG. 5, FIG. 5 is a flow chart of the control method for the storage device according to a third embodiment of the present disclosure.

As shown in FIG. 5, the method may include the following blocks.

In S31, in response to the to-be-written data sent by the host, the to-be-written data may be written into the storage unit through the first mode at a first erase state threshold voltage and/or a first program state threshold voltage. The first erase state threshold voltage may be greater than a second erase state threshold voltage corresponding to the first wear coefficient, and the first program state threshold voltage may be less than a second program state threshold voltage corresponding to the first wear coefficient.

When determining the first wear coefficient, the second erase state threshold voltage and the second program state threshold voltage corresponding to the first wear coefficient may exist. The second erase state threshold voltage may be an erase state voltage corresponding to the first wear coefficient, and the second program state threshold voltage may be a program state voltage corresponding to the first wear coefficient.

The fail bit count may increase as the erase/write count increases, and this is because of electron tunneling. The electron tunneling may cause a tunnel oxide layer of the storage unit to be degraded. An extent of degradation may depend on an electron tunneling rate.

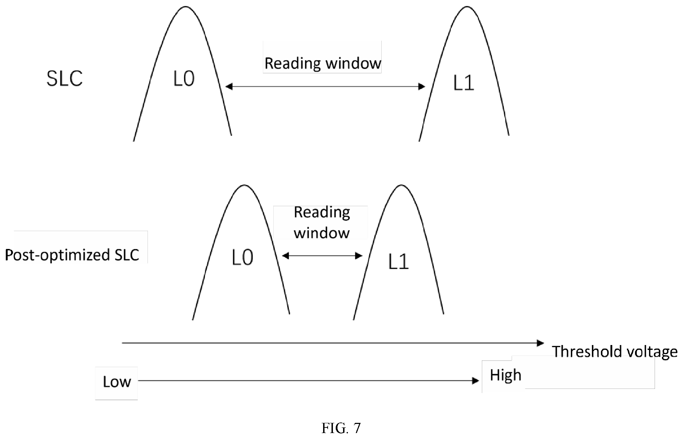

As shown in FIG. 6 and FIG. 7, FIG. 6 is a diagram showing threshold voltages corresponding to the storage unit in the first type and the storage unit in the second type, in the related art; and FIG. 7 is a diagram showing threshold voltages corresponding to the storage unit in the first type and the storage unit in the second type in the third embodiment of the present disclosure.

As shown in FIG. 6, the program state (L1 to L7) threshold voltage of the storage unit in the first type may be relatively high, and the erase state (L0) threshold voltage thereof may be relatively low. Therefore, the amount of electron tunneling may be high, and a greater damage to the storage unit may be caused. As shown in FIG. 7, the threshold voltage corresponding to storage unit in the first type in the related art may be denoted as SLC, and the threshold voltage corresponding to the storage unit in the first type in the third embodiment may be denoted as post-optimized SLC. As can be seen from FIG. 7, a read window corresponding to the post-optimized SLC may be smaller than that of the SLC.

In some embodiments, the first erase state threshold voltage may be 0.2V to 0.3V higher than the second erase state threshold voltage, and the first program state threshold voltage may be 0.2V to 0.3V lower than the second program state threshold voltage. For example, the second erase state threshold voltage may be in a range of 0 to 0.5V, the second program state threshold voltage may be in a range of 2.0V to 2.5V, the first erase state threshold voltage may be in a range of 0.2V to 0.8V, and the first program state threshold voltage may be in a range of 1.8V to 2.2V.

In S32, a second wear coefficient may be obtained. The second wear coefficient may be determined based on the first erase state threshold voltage and/or the first program state threshold voltage, and the second wear coefficient may be smaller than the first wear coefficient.

The erase state threshold voltage may be negatively correlated with the wear coefficient. The program state threshold voltage may be positively correlated with the wear coefficient. The first wear coefficient may be determined based on the first fail bit count corresponding to the storage unit in the first type and the second fail bit count corresponding to the storage unit in the second type. The first wear coefficient may be a positive number less than 1.

Specifically, when the first erase state threshold voltage greater than the second erase state threshold voltage and/or the first program state threshold voltage smaller than the second program state threshold voltage is provided, a goal of a lower electron tunneling amount may be achieved. In this way, the second wear coefficient corresponding to the first erase state threshold voltage and/or the first program state threshold voltage may be smaller than the first wear coefficient, and that is, the second wear coefficient may be smaller than 0.5. Therefore, the write amplification may be further reduced, and the service life of the storage device may be improved.

In S33, a product of the second wear coefficient and the actual erase/write count of the storage unit in the first type may be obtained, and a sum of the product and the actual erase/write count of the storage unit in the second type may be obtained and determined as the target erase/write count.

In S34, in response to the target erase/write count being greater than the erase/write count threshold, the first mode may be shut down.

Parts identical to the first embodiment and the second embodiment may not be repeated herein.

In the present embodiment, by increasing the erase state threshold voltage and/or decreasing the program state threshold voltage, the electron tunneling amount may be reduced, and the corresponding second wear coefficient may be smaller than the first wear coefficient, further reducing the write amplification and improving the service life of the storage device.

In order to further reduce the write amplification, the wear coefficient may be set based on an erase start voltage and a program start voltage, such that the write amplification may be reduced.

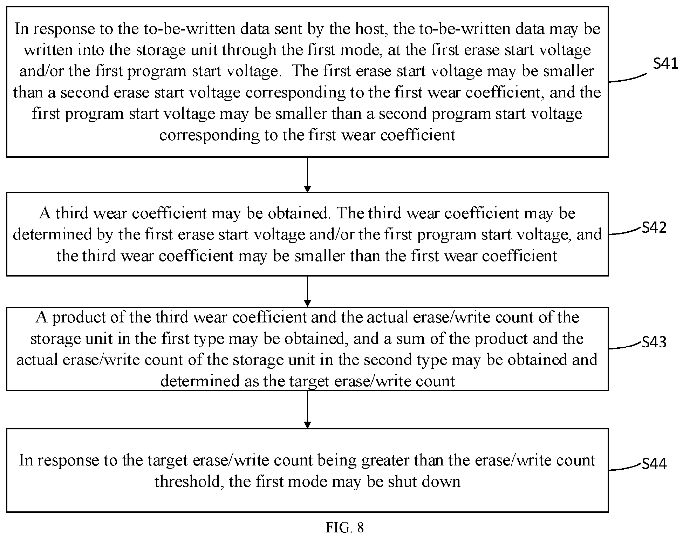

As shown in FIG. 8, FIG. 8 is a flow chart of the control method for the storage device according to a fourth embodiment the present disclosure.

As shown in FIG. 8, the method may include the following block.

In S41, in response to the to-be-written data sent by the host, the to-be-written data may be written into the storage unit through the first mode, at the first erase start voltage and/or the first program start voltage. The first erase start voltage may be smaller than a second erase start voltage corresponding to the first wear coefficient, and the first program start voltage may be smaller than a second program start voltage corresponding to the first wear coefficient.

During transiting between the program state and the erase state, a plurality of pulses may be required. When determining the first wear coefficient, the second erase state threshold voltage, the second program state threshold voltage, the second erase start voltage, and the second program start voltage corresponding to the first wear coefficient may exist. The second erase start voltage may be a start voltage, corresponding to the first wear coefficient, for transitioning from the program state to the erase state. The second program start voltage may be a start voltage, corresponding to the first wear coefficient, for transitioning from the erase state to the program state.

When the erase start voltage and/or the program start voltage is relatively low, a degradation rate of the tunnel oxide layer of the storage unit may be reduced. The degradation rate may depend on the electron tunneling rate. When the erase start voltage and the program start voltage are relatively high, the electron tunneling amount may be high, and damage to the storage unit may be greater.

In S42, a third wear coefficient may be obtained. The third wear coefficient may be determined by the first erase start voltage and/or the first program start voltage, and the third wear coefficient may be smaller than the first wear coefficient.

The erase start voltage may be positively correlated with the wear coefficient, and the program start voltage may be positively correlated with the wear coefficient. The first wear coefficient may be determined based on the first fail bit count corresponding to the storage unit in the first type and the second fail bit count corresponding to the storage unit in the second type. The first wear coefficient may be a positive number less than 1.

Therefore, when the first erase start voltage smaller than the second erase start voltage and/or the first program start voltage smaller than the second program start voltage is provided, a lower electron tunneling amount may be achieved, such that the third wear coefficient corresponding to the first erase start voltage and/or the first program start voltage may be smaller than the first wear coefficient, and that is, the third wear coefficient may be smaller than 0.5. Therefore, the write amplification may be further reduced, and the service life of the storage device may be extended.

In S43, a product of the third wear coefficient and the actual erase/write count of the storage unit in the first type may be obtained, and a sum of the product and the actual erase/write count of the storage unit in the second type may be obtained and determined as the target erase/write count.

In S44, in response to the target erase/write count being greater than the erase/write count threshold, the first mode may be shut down.

Parts identical to the first embodiment and the second embodiment may not be repeated herein.

In some embodiments, while applying the first erase start voltage and the first program start voltage, the first erase state threshold voltage and the first program state threshold voltage may also be applied, such that the corresponding wear coefficient may be further reduced, further reducing the write amplification and extending the service life of the storage device.

In the present embodiment, by reducing the erase start voltage and/or the program start voltage, the electron tunneling amount may be reduced, and the corresponding third wear coefficient may be smaller than the first wear coefficient, further reducing the write amplification and extending the service life of the storage device.

In order to further reduce the write amplification, the wear coefficient may be set based on an erase step value and a program step value, such that the write amplification may be reduced.

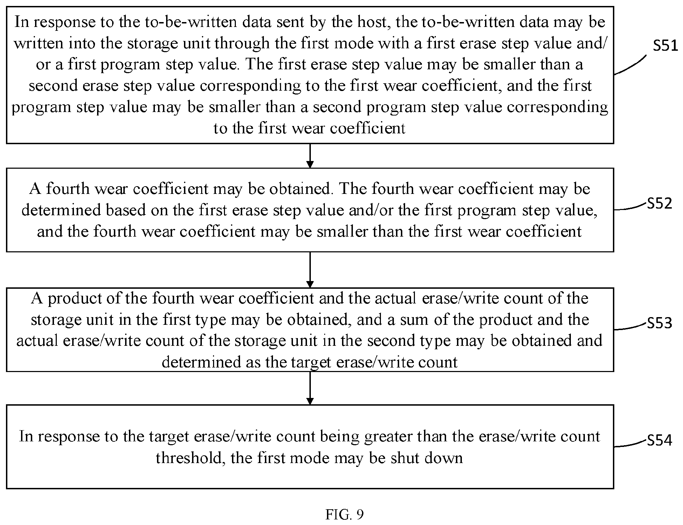

As shown in FIG. 9, FIG. 9 is a flow chart of the control method for the storage device according to a fifth embodiment of the present disclosure.

As shown in FIG. 9, the method may include the following blocks.

In S51, in response to the to-be-written data sent by the host, the to-be-written data may be written into the storage unit through the first mode with a first erase step value and/or a first program step value. The first erase step value may be smaller than a second erase step value corresponding to the first wear coefficient, and the first program step value may be smaller than a second program step value corresponding to the first wear coefficient.

During transiting between the program state and the erase state, a plurality of pulses may be required. When determining the first wear coefficient, the second erase state threshold voltage, the second program state threshold voltage, the second erase start voltage, the second program start voltage, the second erase step value, and the second program step value corresponding to the first wear coefficient may exist. The second erase step value may be a voltage difference, between adjacent pulses, corresponding to the first wear coefficient, for transitioning from the program state to the erase state. The second program step value may be a voltage difference between adjacent pulses, corresponding to the first wear coefficient, for transitioning from the erase state to the program state.

The degradation rate may depend on the electron tunneling rate. When the erase step value and the program step value are high, the electron tunneling amount may be high, causing greater damage to the storage unit. As the erase step value and/or the program step value is lower, the degradation rate of the tunnel oxide layer of the storage unit may be reduced.

In S52, a fourth wear coefficient may be obtained. The fourth wear coefficient may be determined based on the first erase step value and/or the first program step value, and the fourth wear coefficient may be smaller than the first wear coefficient.

The erase step value may be positively correlated with the wear coefficient, and the program step value may be positively correlated with the wear coefficient. The first wear coefficient may be determined by the first fail bit count corresponding to the storage unit in the first type and the second fail bit count corresponding to the storage unit in the second type. The first wear coefficient may be a positive number less than 1.

Therefore, when a first erase step value smaller than the second erase step value and/or a first program step value smaller than the second program step value is provided, a lower electron tunneling amount may be achieved, such that the fourth wear coefficient corresponding to the first erase step value and/or the first program step value may be smaller than the first wear coefficient, and that is, the fourth wear coefficient may be smaller than 0.5. Therefore, the write amplification may be further reduced, and the service life of the storage device may be extended.

In S53, a product of the fourth wear coefficient and the actual erase/write count of the storage unit in the first type may be obtained, and a sum of the product and the actual erase/write count of the storage unit in the second type may be obtained and determined as the target erase/write count.

In S54, in response to the target erase/write count being greater than the erase/write count threshold, the first mode may be shut down.

Parts identical to the first embodiment and the second embodiment may not be repeated herein.

In some embodiments, while the first erase step value and the first program step value are applied, the first erase state threshold voltage and the first program state threshold voltage may also be applied, such that the corresponding wear coefficient may be further reduced, further reducing the write amplification and extending the service life of the storage device.

In some embodiments, while the first erase step value and the first program step value are applied, the first erase start voltage and the first program start voltage may also be applied, such that the corresponding wear coefficient may be further reduced, further reducing the write amplification and extending the service life of the storage device.

In some embodiments, while the first erase step value and the first program step value are applied, the first erase start voltage, the first program start voltage, the first erase state threshold voltage, and the first program state threshold voltage may also be applied, such that the corresponding wear coefficient may be further reduced, further reducing the write amplification and extending the service life of the storage device.

In the present embodiment, by reducing the erase step value and/or the program step value, the electron tunneling amount may be reduced, and the corresponding fourth wear coefficient may be smaller than the first wear coefficient, further reducing the write amplification and extending the service life of the storage device.

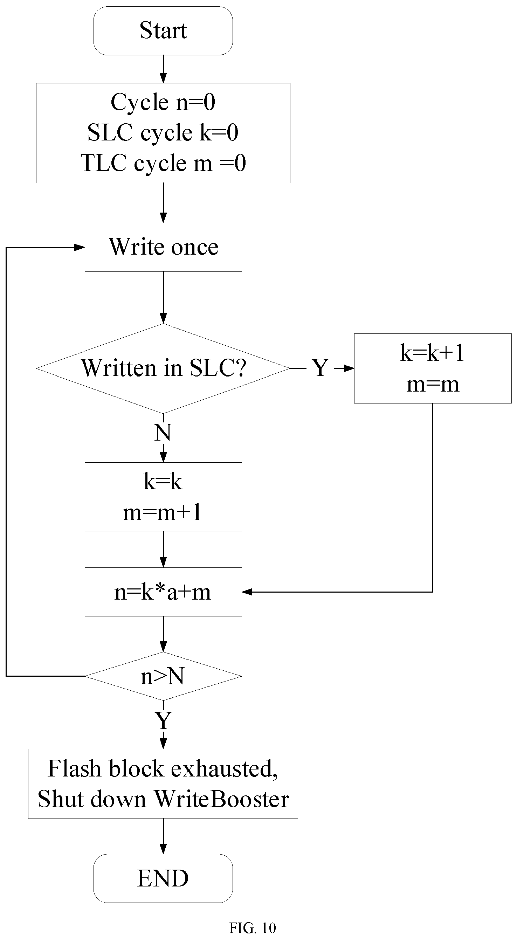

An entire writing process may be illustrated in FIG. 10.

FIG. 10 is a flow chart showing a principle of writing the to-be-written data into the storage unit according to an embodiment of the present disclosure.

As shown in FIG. 10, the target erase/write count may be n, a total erase/write count of the storage device may be N, the erase/write count of the storage unit in the first type may be k, the erase/write count of the storage unit in the second type may be m, and the wear coefficient may be a. When starting to write data, Cycle n = 0, SLC cycle k = 0, TLC cycle m = 0. The data may be written to the entire storage device once. When the first mode (i.e., SLC mode) is applied for writing, k = k + 1, m = m, and the target erase/write count may be: n = k * a + m. When the n is greater than the N, the service life of the flash memory block corresponding to the storage unit may be exhausted, and a WriteBooster function (i.e., the first mode) may be shut down. When the second mode is applied for writing, k = k, m = m + 1, and the target erase/write count may be: n = k * a + m.

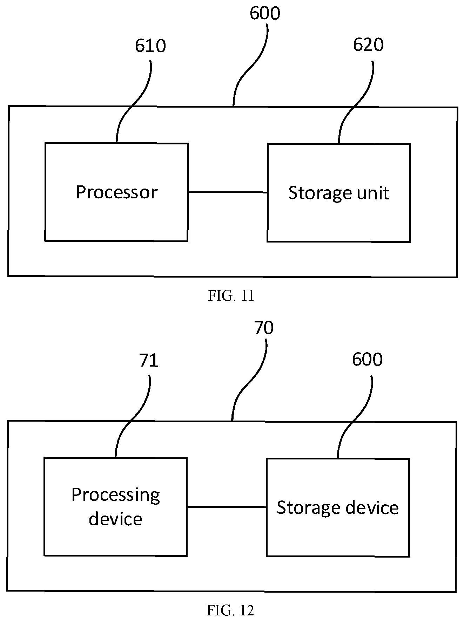

As shown in FIG. 11, FIG. 11 is a schematic structural diagram the storage device according to an embodiment of the present disclosure.

As shown in FIG. 11, the storage device 600 may include a processor 610 and a storage unit 620. The processor 610 may be coupled to the storage unit 620 and the host, and may execute instructions during operation to implement the above control method for the storage device.

As shown in FIG. 12, FIG. 12 is a schematic structural diagram of an electronic device according to an embodiment of the present disclosure.

As shown in FIG. 12, the electronic device 70 may include a processing device 71 and a storage device 600. The processor may be coupled to the storage device 600, and may execute instructions during operation to implement the above control method for the storage device.

According to the above technical solution, the control method for the storage device may be provided. In response to the to-be-written data sent by the host, the to-be-written data may be written into the storage unit through the target mode. The target mode may include at least the first mode and/or the second mode. In the first mode, the to-be-written data may be firstly stored in the storage unit in the first type and then migrated from the storage unit in the first type to the storage unit in the second type. In the second mode, the to-be-written data may be directly stored in the storage unit in the second type. The amount of data that can be stored in each storage unit in the first type may be less than the amount of data that can be stored in each storage unit in the second type. The target erase/write count may be counted according to the target mode. The target erase/write count may be less than the sum of the actual erase/write count of the storage unit in the first type and the actual erase/write count of the storage unit in the second type. In response to the target erase/write count being greater than the erase/write count threshold, the first mode may be shut down. That is, in the present disclosure, the to-be-written data may be written into the storage unit through the target mode including the first mode and/or the second mode, the corresponding target erase/write count may be obtained, and the target erase/write count may be set to be less than the sum of the actual erase/write count of the storage unit in the first type and the actual erase/write count of the storage unit in the second type. In this way, the write amplification may be reduced. That is, the writing mode may be controlled based on the target erase/write count, such that the writing performance of the storage device may be improved, the write amplification may be effectively reduced, and the service life of the storage device may be extended.

The above describes only embodiments of the present disclosure, and are not intended to limit the scope of the present disclosure. Any equivalent structure or equivalent process transformation made based on the description and drawings of the present disclosure, applied directly or indirectly to other related technical fields, shall be equivalently included in the scope of the present disclosure.

## Claims

1. A control method for a storage device, comprising:
in response to to-be-written data sent by a host, writing, through a target mode, the to-be-written data into a storage unit; wherein the target mode comprises a first mode and a second mode; in the first mode, the to-be-written data is firstly stored in a storage unit in a first type and then migrated from the storage unit in the first type to a storage unit in a second type; in the second mode, the to-be-written data is directly stored in the storage unit in the second type; wherein the amount of data storable in the storage unit in the first type is less than the amount of data storable in the storage unit in the second type;
counting a target erase/write count according to the target mode; wherein the target erase/write count is less than a sum of an actual erase/write count of the storage unit in the first type and an actual erase/write count of the storage unit in the second type; and
in response to the target erase/write count being greater than an erase/write count threshold, shutting down the first mode.

2. The control method according to claim 1, wherein, the counting the target erase/write count according to the target mode, comprises:
obtaining a first wear coefficient, wherein the first wear coefficient is determined based on a first fail bit count corresponding to the storage unit in the first type and a second fail bit count corresponding to the storage unit in the second type; and the first wear coefficient is a positive number less than 1; and
obtaining a product of the first wear coefficient and the actual erase/write count of the storage unit in the first type, and obtaining a sum of the product and the actual erase/write count of the storage unit in the second type, and determining the sum as the target erase/write count.

3. The control method according to claim 2, wherein, the first wear coefficient is obtained by:
performing the same number of times of erasing/writing on the storage unit in the first type and on the storage unit in the second type to obtain the first fail bit count corresponding to the storage unit in the first type and the second fail bit count corresponding to the storage unit in the second type; and
determining the first wear coefficient based on the first fail bit count and the second fail bit count.

4. The control method according to claim 1, wherein, the writing the to-be-written data into the storage unit through the target mode, comprises:
writing the to-be-written data into the storage unit according to the first mode, at a first erase state threshold voltage and/or a first program state threshold voltage; wherein, the first erase state threshold voltage is greater than a second erase state threshold voltage corresponding to a first wear coefficient, and the first program state threshold voltage is less than a second program state threshold voltage corresponding to the first wear coefficient;
and
the counting the target erase/write count according to the target mode, comprises:
obtaining a second wear coefficient, wherein the second wear coefficient is determined based on the first erase state threshold voltage and/or the first program state threshold voltage; the second wear coefficient is smaller than the first wear coefficient; the first wear coefficient is determined based on a first fail bit count corresponding to the storage unit in the first type and a second fail bit count corresponding to the storage unit in the second type; the first wear coefficient is a positive number less than 1; and
obtaining a product of the second wear coefficient and the actual erase/write count of the storage unit in the first type, and obtaining a sum of the product and the actual erase/write count of the storage unit in the second type, and determining the sum as the target erase/write count.

5. The control method according to claim 4, wherein, the first erase state threshold voltage is 0.2V to 0.3V higher than the second erase state threshold voltage, and the first program state threshold voltage is 0.2V to 0.3V lower than the second program state threshold voltage.

6. The control method according to claim 1, wherein, the writing the to-be-written data into the storage unit through the target mode, comprises:
writing the to-be-written data into the storage unit according to the first mode, based on a first erase start voltage and/or a first program start voltage; wherein the first erase start voltage is smaller than a second erase start voltage corresponding to a first wear coefficient, and the first program start voltage is smaller than a second program start voltage corresponding to the first wear coefficient;
and
the counting the target erase/write count according to the target mode, comprises:
obtaining a third wear coefficient, wherein the third wear coefficient is determined based on the first erase start voltage and/or the first program start voltage; wherein the third wear coefficient is smaller than the first wear coefficient; the first wear coefficient is determined based on a first fail bit count corresponding to the storage unit in the first type and a second fail bit count corresponding to the storage unit in the second type; the first wear coefficient is a positive number less than 1; and
obtaining a product of the third wear coefficient and the actual erase/write count of the storage unit in the first type, and obtaining a sum of the product and the actual erase/write count of the storage unit in the second type, and determining the sum as the target erase/write count.

7. The control method according to claim 1, wherein, the writing the to-be-written data into the storage unit through the target mode, comprises:
writing the to-be-written data into the storage unit according to the first mode with a first erase step value and/or a first program step value; wherein the first erase step value is smaller than a second erase step value corresponding to a first wear coefficient, and the first program step value is smaller than a second program step value corresponding to the first wear coefficient;
and
the counting the target erase/write count according to the target mode, comprises:
obtaining a fourth wear coefficient, wherein the fourth wear coefficient is determined based on the first erase step value and/or the first program step value; wherein the fourth wear coefficient is smaller than the first wear coefficient; the first wear coefficient is determined based on a first fail bit count corresponding to the storage unit in the first type and a second fail bit count corresponding to the storage unit in the second type; the first wear coefficient is a positive number less than 1; and
obtaining a product of the fourth wear coefficient and the actual erase/write count of the storage unit in the first type, and obtaining a sum of the product and the actual erase/write count of the storage unit in the second type, and determining the sum as the target erase/write count.

8. The control method according to claim 1, wherein, the writing the to-be-written data into the storage unit through the target mode, comprises:
obtaining an available space of the storage device, wherein the storage device comprises a plurality of storage units;
in response to the available space of the storage device being greater than or equal to a preset space, writing the to-be-written data into the storage device through the first mode; or
in response to the available space of the storage device being less than the preset space, writing the to-be-written data into the storage device through the second mode.

9. A storage device, comprising a processor and a storage unit, wherein, the processor is coupled to the storage unit and a host and is configured to execute instructions during operation to implement the control method according to any one of claims 1 to 8.

10. An electronic device, comprising a processing device and a storage device, wherein, the processing device is coupled to the storage device, and is configured to execute instructions during operation to implement the control method according to any one of claims 1 to 8.
